Europäisches Patentamt

European Patent Office

Office européen des brevets

(19)

(11) Numéro de publication: **0 156 696**

**A1**

(12) **DEMANDE DE BREVET EUROPEEN**

(21) Numéro de dépôt: 85400368.8

(22) Date de dépôt: 27.02.85

(51) Int. Cl.⁴: **G 01 V 3/10**

(30) Priorité: 09.03.84 FR 8403661

(43) Date de publication de la demande:
02.10.85 Bulletin 85/40

(84) Etats contractants désignés:
DE GB IT

(71) Demandeur: PETERCEM S.A.
61, Route de Grenoble B.P. 320
F-69808 Saint Priest-Cédex(FR)

(72) Inventeur: Macovschi, Mihail
133, Cours Albert Thomas
F-69003 Lyon(FR)

(74) Mandataire: Laget, Jean-Loup et al,
Cabinet Pierre Loyer 18, Rue de Mogador
F-75009 Paris(FR)

(54) Capteur de la position relative d'une cible par rapport à une cible de référence.

(57) Deux capteurs 3, 4 détectent une cible 1 et une cible de référence 2. A une fréquence d'échantillonnage imposée par une horloge 18, on commande l'oscillation amortie des deux capteurs et on détecte les passages par zéro des deux oscillations pour apprécier la position relative des deux cibles.

EP 0 156 696 A1

./...

Croydon Printing Company Ltd.

*Fig:1*

Capteur de la position relative d'une cible par rapport
à une cible de référence.

L'invention concerne un capteur de la position relative d'une
cible par rapport à une cible de référence.

Il est connu, au moyen d'un capteur inductif, de détecter le
passage d'une cible par une position prédéterminée au cours
de son mouvement relatif de rapprochement ou d'éloignement
par rapport au capteur. Un tel capteur est décrit dans le
brevet FR-A-2.522.830. Un capteur de ce type effectue une
détection dans l'absolu, qui peut paraître insuffisante.

Un but de l'invention est de proposer un capteur susceptible
d'indiquer la position d'une cible par rapport à une position
prédéterminée matérialisée par une cible de référence.

Un autre but de l'invention est de prévoir la détection d'une
cible lors de son passage dans une position correspondant à
celle d'une cible de référence qui, elle, est en position réglable.

L'invention a pour objet un capteur de la position relative
d'une cible par rapport à une cible de référence, du type
comprenant un capteur inductif de proximité, caractérisé en
ce qu'il comporte : un premier capteur électromagnétique de
la position de la cible et un second capteur électromagnétique de la position de la cible de référence, chacun de ces
deux capteurs étant alimenté en tension de référence par
l'intermédiaire d'un commutateur et relié à la masse par l'intermédiaire d'un condensateur ; une horloge d'échantillonnage commandant périodiquement la commutation desdits commutateurs vers la masse de façon à provoquer la décharge oscillante amortie des capteurs ; deux comparateurs pour détecter le passage par zéro des tensions aux bornes desdites capacités ; et une bascule alimentée par lesdits comparateurs, pour délivrer un signal logique correspondant à la position relative de la cible par rapport à la position de la cible de référence.

Selon d'autres caractéristiques de l'invention :

- Le comparateur relatif au capteur de position de la cible de référence est relié à la bascule par l'intermédiaire d'un interrupteur dont la fermeture est commandée par l'horloge d'échantillonnage.

- La fréquence maximale d'échantillonnage de l'horloge d'échantillonnage est environ dix fois plus faible que la fréquence d'oscillation amortie des capteurs.

- L'échantillonnage est commandé par une séquence aléatoire ou pseudo-aléatoire.

- Les deux capteurs sont des enroulements juxtaposés, leur noyau commun jouant à la fois le rôle de cible pour le capteur de mesure, et de cible de référence pour le capteur de référence, de façon à fournir la direction du noyau et sa distance par rapport à la position d'équilibre.

D'autres caractéristiques de l'invention ressortiront de la description qui suit faite avec référence au dessin annexé sur lequel on peut voir :

Figure 1 : un schéma symbolique simplifié d'un capteur de la position relative d'une cible par rapport à une cible de référence, selon l'invention :

Figure 2 : une représentation des signaux de tension utilisés pour la détection de la position relative de la cible par rapport à la cible de référence, dans le capteur de la figure 1 ;

Figure 3 : un exemple de réalisation pratique particulier du capteur de position relative de la figure 1, limité aux circuits magnétiques.

En se reportant au dessin, on peut voir que le capteur de la position relative d'une cible 1 par rapport à une cible de référence 2 se compose essentiellement de deux capteurs électromagnétiques proprement dits 3 et 4, identiques, et d'un circuit électronique de traitement de signaux et d'échantillonnage. Chacun des deux capteurs 3, 4 est constitué d'une armature 5, 6 et d'un enroulement 7, 8. Chaque enroulement 7, 8 est relié d'une part à la masse par l'intermédiaire d'une capacité 9, 10, respectivement, d'autre part à une tension de référence continue 17 par l'intermédiaire d'un commutateur 11, 12 respectivement. Les deux commutateurs 11, 12 assurent à l'état de repos, l'alimentation de l'enroulement 7, 8 et de la capacité 9, 10 par la tension de référence 17. En position de travail, ils assurent la liaison à la masse de l'enroulement 7, 8, c'est-à-dire la fermeture sur lui-même du circuit oscillant constitué par l'enroulement 7, 8 et la capacité 9, 10, respectivement. Ces commutateurs sont commandés simultanément.

Le point commun 13, 14 à l'enroulement 7, 8 et à la capacité 9, 10 respectivement, est relié à une entrée d'un comparateur 15, 16, respectivement dont l'autre entrée est reliée à la masse.

Le signal de sortie du comparateur 15 est appliqué d'une part à une horloge d'échantillonnage 18, et d'autre part à l'entrée D d'une bascule 19 de type D. Le signal de sortie du comparateur 16 est appliqué d'une part à l'horloge d'échantillonnage 18 et d'autre part, par l'intermédiaire d'un interrupteur 20 normalement ouvert, à l'entrée C de la bascule 19. Cette entrée C de la bascule 19 est par ailleurs reliée à la masse par l'intermédiaire d'une résistance 21. Enfin, la sortie Q de la bascule 19 délivre en 22 le signal de détection du passage de la cible 1 par la position correspondant à celle de la cible de référence 2.

Le fonctionnement du capteur selon l'invention est le suivant: en temps normal, on alimente en permanence les deux capteurs 3 et 4 au moyen de la tension de référence continue 17, et, en conséquence, la capacité 9, 10 est chargée à cette tension. Périodiquement, et avec une fréquence d'échantillonnage déterminée par l'horloge d'échantillonnage 18, on commande la commutation des commutateurs 11 et 12 vers la masse, ainsi que de l'interrupteur 20 qui devient fermé. Les circuits oscillants 7 - 9 et 8 - 10 se déchargent en oscillations amorties. Au moyen des comparateurs 15, 16, on détecte le passage par zéro des tensions aux points 13, 14 respectivement, qui se produisent avec un décalage dans le temps si les deux cibles 1 et 2 ne sont pas dans la même position par rapport aux armatures 5 et 6 respectivement. Après ces passages par zéro, l'horloge d'échantillonnage commande le retour à l'état initial des commutateurs 11, 12 et de l'interrupteur 20. La bascule 19 ayant reçu successivement les deux signaux de sortie des comparateurs 15 et 16 délivre en 22 un signal correspondant à la position relative de la cible 1 par rapport à la cible de référence 2, qui peut être utilisé pour visualisation à distance par exemple. Ce signal de sortie indique notamment si la cible 1 est plus éloignée que la cible 2 ou, au contraire, plus proche que la cible 2.

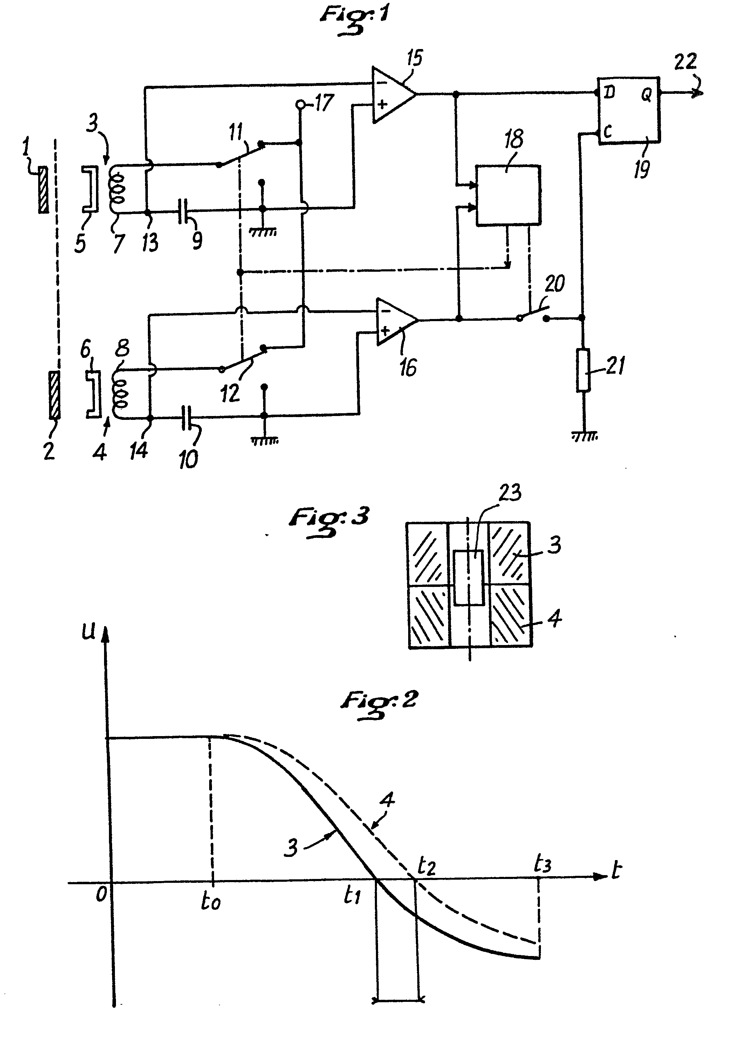

Sur la figure 2, on a symbolisé en $t_o$ l'instant de la commutation déclenchée par l'horloge d'échantillonnage 18, en $t_1$ le passage par zéro de l'oscillation amortie correspondant au point 13, en $t_2$ le passage par zéro correspondant au point 14, et en $t_3$ l'instant du retour à l'état initial commandé par l'horloge d'échantillonnage 18. L'écart entre les instants $t_1$ et $t_2$ permet de déterminer par son sens, la position de la cible 1 par rapport à la cible de référence 2 (plus éloignée ou moins éloignée).

Lorsque la cible 1 est très voisine de la position de la cible 2 de référence, l'écart entre les instants $t_1$ et $t_2$ est très faible et la détection est difficile. On peut alors au moyen de l'horloge d'échantillonnage 18, compter plusieurs passages successifs par zéro des signaux aux points 13 et 14, et par exemple après trois passages par zéro, commander la fermeture de l'interrupteur 20. Les écarts de temps sont alors vus avec plus de précision, ce qui augmente la précision de la mesure.

Pour bien détecter les passages par zéro de la tension aux points 13 et 14, il faut que l'amortissement des oscillations ne soit pas trop important, de façon à voir un franchissement net du zéro. Par ailleurs, il faut que la fréquence d'échantillonnage soit nettement plus faible (environ 10 fois au moins) que la fréquence d'oscillation de façon à ne pas faire de nouvelle mesure avant la stabilisation de la charge des capacités 9 et 10.

Cette fréquence d'échantillonnage peut être réglée de l'extérieur. On peut utiliser également une séquence d'échantillonnage aléatoire ou pseudo-aléatoire.

Dans le cas particulier de la figure 3, on peut considérer que les capteurs 3 et 4 sont deux enroulements juxtaposés, avec éventuellement une armature interne, et que le noyau 23 joue à la fois le rôle de cible 1 et de cible de référence 2.

En effet, il est cible de référence pour le capteur 4 et cible pour le capteur 3. La condition supplémentaire imposée par ce mode de réalisation est que la cible de référence n'est pas fixe, c'est-à-dire que le point de passage par zéro de la tension en 14 n'est pas fixe : les instants $t_1$ et $t_2$ se rapprochent, ou s'éloignent, l'un de l'autre, lorsque le noyau 23 se déplace. Mais la solution du problème est la même. Le signal de sortie 22, qui est un signal logique 1 ou 0, permet de visualiser la direction du noyau par rapport à la position d'équilibre, et l'intervalle de tems $|t_2 - t_1|$ permet de mesurer son écart par rapport à la position d'équilibre.

Dans le cas de la figure 3, la mesure de l'intervalle de temps $(t_2 - t_1)$, par exemple par comptage d'impulsions, permet de donner une valeur de la position du noyau.

L'identité du premier signal arrivant permet de définir la direction du noyau par rapport à la position d'équilibre. On peut ainsi, après étalonnage, avoir une mesure relativement précise donnant par son signe par exemple la direction du noyau, et par sa valeur absolue la distance du noyau par rapport à sa position d'équilibre.

Sur la figure 1, on a symbolisé les commutateurs 11, 12 et 20 comme des commutateurs mécaniques, il va de soi qu'ils sont avantageusement réalisés sous forme de commutateurs électroniques statiques.

Revendications

1. - Capteur de la position relative d'une cible par rapport à une cible de référence, du type comprenant un capteur inductif de proximité, caractérisé en ce qu'il comporte : un premier capteur électromagnétique (3) de la position de la cible (1) et un second capteur électromagnétique (4) de la position de la cible de référence (2), chacun de ces deux capteurs (3, 4) étant alimenté en tension de référence continue (17) par l'intermédiaire d'un commutateur (11, 12) et relié à la masse par l'intermédiaire d'un condensateur (9, 10) ; une horloge d'échantillonnage (18) commandant la commutation desdits commutateurs (11, 12) vers la masse de façon à provoquer la décharge oscillante amortie des capteurs (3, 4) ; deux comparateurs (15, 16) pour détecter le passage par zéro des tensions aux bornes desdites capacités (9, 10); et une bascule (19) alimentée par lesdits comparateurs, pour délivrer un signal logique correspondant à la position relative de la cible (1) par rapport à la position de la cible de référence (2).

2. - Capteur selon la revendication 1, caractérisé en ce que le comparateur (16) relatif au capteur (4) de position de la cible de référence (2) est relié à la bascule (19) par l'intermédiaire d'un interrupteur (20) dont la fermeture est commandée par l'horloge d'échantillonnage (18).

3. - Capteur selon la revendication 1, caractérisé en ce que la fréquence maximale d'échantillonnage de l'horloge d'échantillonnage (18) est environ dix fois plus faible que la fréquence d'oscillation amortie des capteurs (3, 4).

4. - Capteur selon la revendication 1, caractérisé en ce que l'échantillonnage est commandé par une séquence aléatoire ou pseudo-aléatoire.

5. - Capteur selon la revendication 1, caractérisé en ce que

0156696

les deux capteurs (3, 4) sont des enroulements juxtaposés, leur noyau commun (23) jouant à la fois le rôle de cible (1) pour le capteur de mesure (3), et de cible de référence (2) pour le capteur de référence (4), de façon à fournir la direction du noyau et sa distance par rapport à la position d'équilibre.

Fig. 1

Fig. 3

Fig. 2

Office européen
des brevets

**RAPPORT DE RECHERCHE EUROPEENNE**

EP 85 40 0368

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 515 984 (KING AND McCLAREN) * Colonne 3, lignes 18-70; colonne 4, lignes 45-72; figures 1-4 * | 1 | G 01 V 3/10 |
| | --- | | |
| A | JOURNAL DE L'EQUIPEMENT ELECTRIQUE ET ELECTRONIQUE, no. 306, novembre 1970, pages 116-117, Paris, FR; "Conception et développement de capteurs de proximité" * Figure 1 * | 1 | |
| | --- | | |
| A,D | EP-A-0 090 689 (PETERCEM) | 1 | |
| | ----- | | |

DOMAINES TECHNIQUES
RECHERCHES (Int. Cl.4)

G 01 K
H 03 K
G 01 D
F 42 C
G 01 B

Le présent rapport de recherche a été établi pour toutes les revendications

| Lieu de la recherche | Date d'achèvement de la recherche | Examinateur |
|---|---|---|
| LA HAYE | 12-06-1985 | ANDERSON A.TH. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82